# EUROPÄISCHE PATENTSCHRIFT

(11) **EP 1 916 771 B1**
(45) Veröffentlichungstag und Bekanntmachung des Hinweises auf die Patenterteilung: **23.12.2009**
(21) Anmeldenummer: 07115504.8
(22) Anmeldetag: 03.09.2007
(51) Int. Cl.: H03M 3/00

(54) **Delta-Sigma-Datenkonverter-Anordnung und Verfahren zum Überprüfen eines Delta-Sigma-Datenkonverters**
Delta-sigma data converter and method for monitoring a delta-sigma data converter
Convertisseur de données delta-sigma et procédé de surveillance d'un convertisseur de données delta-sigma

(30) Priorität: 25.10.2006 DE 102006050175
(43) Veröffentlichungstag der Anmeldung: 30.04.2008
(73) Patentinhaber: ROBERT BOSCH GMBH, 70442 Stuttgart (DE)
(72) Erfinder: Beckert, Matthias, 72768 Reutlingen (DE); Wieja, Thomas, 72810 Gomaringen (DE); Neuscheler, Marco, 72768 Reutlingen (DE); Brockmann, Markus, 72074 Tuebingen (DE); Henning, Christiane, 72070 Tuebingen (DE)

(56) Entgegenhaltungen:
- GB-A- 2 266 205
- US-A- 5 959 562
- KUEN-JONG LEE ET AL: "A sigma-delta modulation based BIST scheme for A/D converters" TEST SYMPOSIUM, 2003. ATS 2003. 12TH ASIAN 16-19 NOV. 2003, PISCATAWAY, NJ, USA,IEEE, 16. November 2003 (2003-11-16), Seiten 124-127, XP010672474 ISBN: 0-7695-1951-2
- LUIS ROLÍNDEZ ET AL: "A BIST Scheme for SNDR Testing of [Sigma][Delta] ADCs Using Sine-Wave Fitting" JOURNAL OF ELECTRONIC TESTING ; THEORY AND APPLICATIONS, KLUWER ACADEMIC PUBLISHERS, BO, Bd. 22, Nr. 4-6, 18. Januar 2007 (2007-01-18), Seiten 325-335, XP019466127 ISSN: 1573-0727

## Beschreibung

### Stand der Technik

Datenkonverter nach dem Prinzip der Delta-Sigma Modulation werden für vielfältige Anwendungen eingesetzt. Sie weisen günstige Linearitätseigenschaften auf und werden unter anderem bei Anwendungen eingesetzt, bei denen eine hohe Auflösung bei limitierter Bandbreite gefordert ist. Ein bevorzugter Einsatzbereich sind Delta-Sigma-Analog/Digital-Wandler (ΔΣ-ADC) in der Signalverarbeitung, z. B. bei der Auswertung von Sensorsignalen.

Bei Delta-Sigma-Modulatoren wird das zu konvertierende Signal in Form einer Pulsdichte modulierten Signalfolge bei einer niedrigen Wortbreite, häufig 1 Bit, und hoher Bandbreite dargestellt. Hierbei wird das Ausgangssignal eines Delta-Sigma-Modulators innerhalb des Modulators nach Digital-Analog-Wandlung auf den Eingang zurückgekoppelt. Da die Wortbreite niedrig ist, sind die erforderlichen Strukturen, insbesondere der D/A-Wandler einfach darstellbar und erreichen hohe Linearitätswerte.

Aufgrund der prinzipbedingt erforderlichen Überabtastung, (d. h., wenn die durch die Abtastrate definierte Bandbreite sehr groß gegenüber der Nutzsignalbreite ist), und der hohen Auflösung der Eingangssignale werden hierbei an die Prüfeinrichtungen hohe Ansprüche gestellt. Insbesondere unter Serienbedingungen führen die resultierenden Anforderungen an die Genauigkeit der Prüfeinrichtungen zu aufwendigen und kostenintensiven Lösungen. Die hohe Auflösung verursacht in Kombination mit der beschriebenen Überabtastung lange Testzeiten und damit entsprechend hohe Stückkosten.

Neben externen Prüfvorrichtungen werden zum Teil auch interne Prüfvorrichtungen vorgesehen, um die Testzeiten zu minimieren und die erforderlichen Testsignale intern zu generieren. Zur Charakterisierung und zum Test von Delta-Sigma-Wandlern wurden bereits unterschiedliche Verfahren von Selbsttests, unter anderem BIST (build in self test) und deren Implementierung veröffentlicht.

In Chee-Kian Ong, Kwang-Ting (Tim) Cheng und Li-C. Wang "Delta-sigma Modulator Based Mixed-signal BIST Architecture for SoC" Design Automation Conference, 2003, Proceedings of the ASP-DAC 2003, Asia and South Pacific 21-24 Jan., 2003 Page(s): 669 - 674, wird eine BIST-Architektur auf Basis eines Delta-Sigma-Modulators zweiter Ordnung vorgeschlagen. Hierbei ist ein Design-For-Testability (DfT)-Schaltkreis vorgesehen, der für einen Test bzw. eine Charakterisierung des Modulators unter Verwendung eines digitalen Testsignals geeignet ist. Die Evaluierung des BIST-Verfahrens erfolgt hierbei jedoch im Wesentlichen in Software.

In Kuen-Jong Lee; Soon-Jyh Chang; Ruei-Shiuan Tzeng, "A Delta-Sigma modulation based BIST scheme for A/D converters"; Test Symposium, 2003, ATS 2003, 12th Asian 16 - 19 Nov. 2003 Seite 124 - 127 wird ein BIST-Verfahren zur Messung der vier Schlüsselparameter von A/D-Konvertern, nämlich dem Offset-Fehler, dem Verstärkungsfehler, der Integral- Nichtlinearität und der Differential-Nichtlinearität beschrieben. Hierbei wird ein Delta-Sigma-Modulator beschrieben, der analoge Sinosoidal -Testsignale und digitale Sinosoidal -Referenzsignale auf dem Chip (on Chip) erzeugen kann. Hierbei werden die Ausgangssignale des Analog-Digital-Wandlers mit denjenigen von erzeugten Digital-Referenzsignalen verglichen, wobei die Parameter auf Basis hierzu ermittelter Gleichungen bestimmt werden. Der bei einem derartigen Verfahren sowie bei einer derartigen Testschaltung erforderliche Hardware-Aufwand auf den ICs ist jedoch erheblich.

Offenbarung der Erfindung

Erfindungsgemäß wird auf Hardware-Basis, insbesondere On Chip, ein Selbsttest des Delta-Sigma-Datenkonverters ermöglicht. Hierbei können vorteilhafterweise sowohl die analogen als auch die digitalen Baugruppen des Delta-Sigma-Datenkonverters getestet werden.

Erfindungsgemäß sind ein Delta-Sigma-ADC und eine Prüfvorrichtung zu dessen Prüfung vorgesehen; der Delta-Sigma-ADC weist - in an sich bekannter Weise - einen Delta-Sigma-Modulator zur Aufnahme eines analogen Eingangssignals und Ausgabe eines digitalen Datenstroms sowie eine diesen Datenstrom aufnehmende digitale Filtereinrichtung auf.

Der Erfindung liegt der Gedanke zu Grunde, intern innerhalb der Prüfeinrichtung ein Testsignal, vorzugsweise mit einer minimalen Wortbreite, zu erzeugen und an eine digitale Referenzeinrichtung einzugeben, die idealisierte Eigenschaften des zu prüfenden analogen Delta-Sigma-Modulators aufweist und ein Referenzsignal an die digitale Filtereinrichtung ausgibt. Hierbei können sukzessive verschiedene Testmodi durchgeführt werden, die eine Überprüfung der einzelnen Komponenten ermöglichen.

Erfindungsgemäß werden hierbei die besonderen Eigenschaften eines Delta-Sigma-Modulators ausgenutzt, der eine interne Rückkopplung seines eine pulsdichtemodulierte Signalfolge beschreibenden Ausgangssignals an seinen Eingang aufweist. Erfindungsgemäß wird dieser Sachverhalt ausgenutzt, indem in der Prüfeinrichtung intern ein digitales Testsignal erzeugt wird, das vorzugsweise eine geringe bzw. minimale Wortbreite aufweist und vorteilhafterweise bezüglich seiner Bandbreite dem modulierten Ausgangssignal des zu prüfenden Delta-Sigma-Modulators im wesentlichen entspricht.

Zur Einkopplung dieses Testsignals durch die Prüfungseinrichtung in den analogen Signalpfad kann daher eine gleiche Anordnung verwendet werden, die intern im Delta-Sigma-Modulator für die Rückkopplung des Ausgangssignals bzw. die Abtastung des analogen Eingangssignals eingesetzt wird.

Die digitale Referenzeinrichtung kann hierbei insbesondere ein digitaler Delta-Sigma- Referenzmodulator sein, der den analogen Delta-Sigma-Modulator, d.h. insbesondere dessen Übertragungsfuktion bzw. z- Transformation als digitales Rechenmodel nachbildet. Indem ein Testsignal-Generator das Testsignal digital an die digitale Referenzeinrichtung und weiterhin analog an den zu prüfenden Delta-Sigma-Modulator ausgibt, können durch entsprechendes Umschalten die Ausgänge der beiden Modulatoren bei prinzipiell identischen bzw. entsprechenden Eingangssignalen miteinander verglichen und Abweichungen ihrer Ausgangswerte direkt als Fehler bzw. Ungenauigkeiten erkannt werden.

Als Testsignal-Generator kann insbesondere wiederum ein digitaler Delta-Sigma-Modulator vorgesehen sein, der als Testsignal einen Datenstrom ausgibt; hierbei kann insbesondere ein Datenstrom der Wortbreite 1 Bit ausgegeben werden. Dem Testsignal-Generator können zum einen vorgegebene Testdaten von z. B. einer externen Steuereinrichtung zugeführt werden, die z. B. vorgegebene Werte durchlaufen, und zum anderen das digitale Ausgangssignal rückgekoppelt werden.

Bei einer Wortbreite von 1 Bit, z. B. bei einem Wertebereich +1, -1, kann die D/A-Wandlung des Testsignals durch Abtasten der Referenzspannungen erfolgen. Wenn die Referenzspannungen dieser D/A-Wandlung identisch mit der Referenzspannung des Delta-Sigma-ADC ist, und zum Abtasten die Eingangsstruktur des Delta-Sigma-ADC verwendet wird, ist eine optimale Einkopplung des Digital-Testsignals in den analogen Signalpfad darstellbar.

Erfindungsgemäß kann somit zum einen strukturbedingt eine Genauigkeit bei der Einkopplung des Testsignals erreicht werden, die der Genauigkeit des zu prüfenden Modulators zumindest entspricht. Weiterhin kann ein Testsignal hoher Bandbreite eingespeist werden, was eine Optimierung der Testzeit bei vollständiger Prüfung über den gesamten Wertebereich ermöglicht.

Erfindungsgemäß sind unterschiedliche Testverfahren möglich. Ein erster Testmodus kann zur grundsätzlichen Funktionsprüfung dienen. Zunächst können die an den Testsignal-Generator direkt eingegebenen Testdaten dazu dienen, über den digitalen Referenzmodulator die Funktionsfähigkeit bzw. Funktionsprüfung des Testsignal-Generators, des Referenzmodulators und des digitalen Filters zu überprüfen, um nachfolgend eine genauere Prüfung des analogen Delta-Sigma-Modulators vorzunehmen.

In einem zweiten Testmodus wird in Modifikation zum ersten Testverfahren das digitale Ausgangssignal auf den Eingang des Testsignal-Generators gelegt; somit arbeitet der gesamte Signalpfad als synchrones digitales Netzwerk, so dass ein Test auf Basis von "Testpattern" durch wiederholte Prüfung der Ausgangsdaten auf Identität mit den entsprechenden Simulationsergebnissen erfolgen kann.

In einem dritten Testmodus werden dann der zu prüfende analoge Delta-Sigma-Modulator mit dem digitalen Referenz-Modulator verglichen, indem das Testsignal analog in den Delta-Sigma-Modulator und digital in den Referenz-Modulator eingespeist und anschließend durch Differenzbildung verglichen wird. Der extrem beschränkte Eingangswertebereich des Referenzmodels von z. B. (+1; -1) führt dabei zu einer vergleichsweise geringen internen Wortbreite und damit zu einer flächenoptimalen Implementierung.

Das Ergebnis der Differenzbildung ist die Überlagerung der Nutzsignale und des jeweiligen Quantisierungsrauschens beider Modulatoren. Während die Differenz der Nutzsignale (bei idealer Übereinstimmung) den Wert "0" ergibt, überlagert sich das Rauschen unkorreliert. Wie beim Delta-Sigma-Wandler müssen daher die Rauschanteile außerhalb des Nutzbandes durch entsprechende Filterung eliminiert werden.

Die Filterung kann im Testbetrieb wie im Normalbetrieb durch ein "DezimierFilter" und nachfolgendes "Tiefpass Filter" erfolgen. Diese digitalen Filterstufen bewirken eine Erhöhung der Wortbreite bei gleichzeitiger Reduzierung der Signalbandbreite. Im Testbetrieb werden diese Filterstufen des Delta-Sigma -ADC zur Beseitigung der Rauschanteile des zu prüfenden Delta-Sigma -Modulators und seines Referenzmodels gleichermaßen genutzt.

Durch Umschaltung in verschiedene Testbetriebsarten erfolgt somit sukzessive ein lückenloser funktionaler Test der gesamten Anordnung. Die gefilteren Ausgangswerte liegen in digitaler Form vor und können direkt als Maß für die Abweichung, d.h. als Fehlerkennlinie, des Delta-Sigma-Datenkonverters von der idealen Übertragungscharakteristik im jeweiligen Arbeitspunkt herangezogen werden. Aus dem Ergebnis lassen sich mögliche Fehlerterme, insbesondere Offset, Steigung und nichtlineare Fehler mit bekannten mathematischen Verfahren herleiten und gegebenenfalls durch entsprechende Korrekturrechnung kompensieren.

Erfindungsgemäß ist der erforderliche schaltungstechnische Zusatzaufwand nahezu vollständig digital darstellbar. Hierdurch können unkontrollierte parametrische Einflüsse auf die Testschaltung für beliebig hohe Genauigkeiten eliminiert werden. Weiterhin kann der kostenrelevante Aufwand in Form von Siliziumfläche gering gehalten werden; dies kann bereits bei den zur Ausbildung des Delta-Sigma-Wandlers herkömmlich eingesetzten Halbleiterprozessen erfolgen.

### Kurze Beschreibung der Zeichnungen

- Fig. 1: zeigt ein Schaltbild einer erfindungsgemäßen Delta-Sigma-Datenkonverter-Anordnung gemäß einer Ausführungsform mit den jeweiligen Signal- bzw. Datenverläufen;
- Fig. 2: zeigt ein Diagramm der Magnitude des digitalen Testsignals in Abhängigkeit vom Testdaten-Eingangssignal;
- Fig. 3: zeigt eine kombinierte Ausführungsform des analogen Eingangsmultiplexers und des D/A-Wandlers des Testsignal-Generators aus Fig. 1;
- Fig. 4: zeigt ein Flussdiagramm eines erfindungsgemäßen Testverfahrens.

### Beschreibung der Ausführungsformen

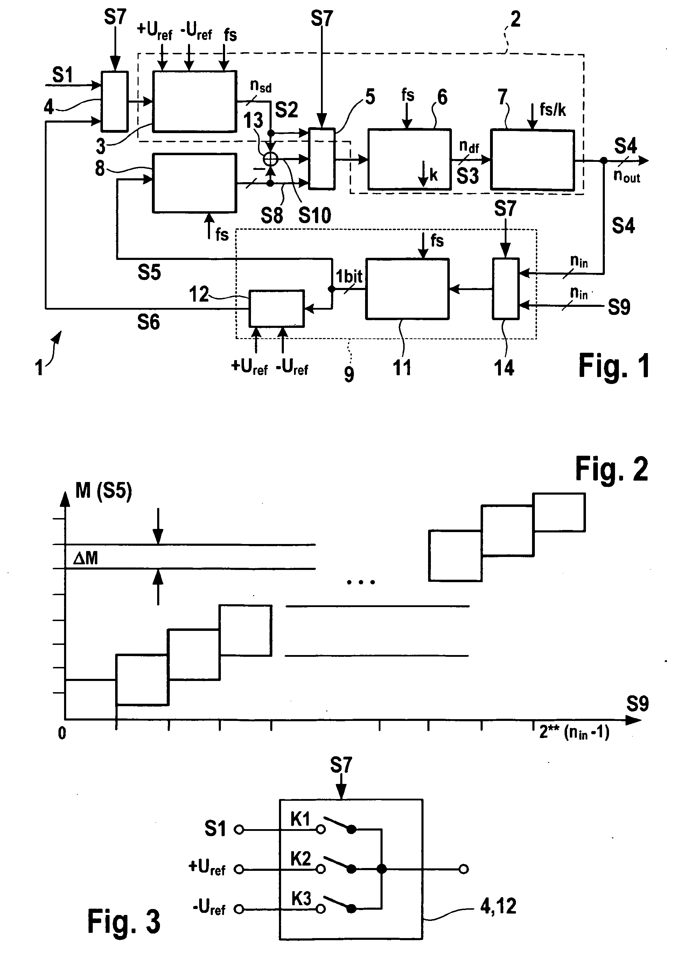

Eine Delta-Sigma-Datenkonverter-Anordnung 1 weist gemäß Figur 1 einen durch gestrichelte Linien abgegrenzten Delta-Sigma- Analog-Digital- Wandler (ΔΣ-ADC) 2 auf, der ein analoges Eingangssignal S1, z. B. das Messsignal eines Sensors, aufnimmt und in an sich bekannter Weise ein digitales Ausgangssignal S4 ausgibt, das z. B. von einer übergeordneten Steuereinrichtung oder Auswerteeinrichtung aufgenommen wird. Der ΔΣ-ADC 2 weist hierzu einen analogen Delta-Sigma-Modulator (ΔΣ- Modulator) 3 auf, der über einen als Schalter dienenden und für den normalen Betrieb nicht relevanten Eingangsmultiplexer 4 das analoge Eingangssignal S1 aufnimmt.

Der analoge ΔΣ- Modulator 3 führt in an sich bekannter Weise innerhalb seiner Eingangsstufe eine zeitliche Diskretisierung des analogen Eingangssignals S1 durch mit einer Abtastung mit der hochfrequenten Abtastfrequenz fs. Hierbei ist der ΔΣ -Modulator 3 an die Referenzspannungen +U_{ref} und -U_{ref} angeschlossen und kann somit analoge Spannungssignale S1 innerhalb des durch U_{ref} definierten Spannungsbereichs in ein digitales, Pulsdichte moduliertes Datenstromsignal S2 mit einer niedrigen Wortbreite n_{sd} und der Bandbreite fs/2 ausgeben. Der analoge ΔΣ -Modulator 3 weist z. B. einen herkömmlichen Aufbau mit einem Integrator zur Integration bzw. Summenbildung eines analogen Spannungswertes, einen z. B. durch einen Komparator ausgebildeten Quantisierer und ggf. einen Ausgangsspeicher auf, der in Abhängigkeit des angeschlossenen Taktsignals fs das Datenstromsignal S2 ausgibt; hierbei erfolgt eine negative Rückkopplung seines Ausgangssignals bzw. digitalen Datenstroms S2 über einen Digital-Analog-Wandler auf einen analogen Addierer, der die Differenz des zu detektierenden analogen Eingangssignal S1 mit diesem analogen Rückkopplungs-Signal bildet. In Abhängigkeit des analogen Eingangssignals S1 wird somit der Datenstrom S2 als Pulsdichte moduliertes Signal gebildet. Vorteilhafterweise kann der analoge ΔΣ-Modulator 3 mit einer Wortbreite n_{sd} = 1 Bit ausgebildet sein, so dass das Signal S2 einen Pulsdichte modulierten Bit-Strom bildet, was zu einer hohen Linearität führt. Das Taktsignal fs kann z. B. im Bereich von zwei bis drei MHz liegen und gegenüber dem nachfolgend ausgegebenen digitalen Ausgangssignal S4 somit eine deutliche Überabtastung liefern, die sehr groß gegen 1 ist, z. B. im Bereich von 1000.

Der digitale Datenstrom S2 wird über einen als Schalter dienenden Multiplexer 5 einem digitalen Dezimierfilter 6 zugeführt, das eine Filterung und Abtastratenreduzierung um einen Faktor k durchführt und ein Ausgangssignal S3 der Wortbreite n_{df} mit n_{df} >> n_{sd} und der Bandbreite fs/2k bereitstellt. Ein im Signalpfad folgendes digitales Tiefpassfilter 7 nimmt dieses Signal S3 auf und dient zur Unterdrückung der in ihm enthaltenen Rauschanteile und zur Kompensation der Übertragungscharakteristik im Nutzband. Es gibt das digitale Ausgangssignal S4 mit der Wortbreite nₒᵤₜ aus.

Erfindungsgemäß ist zusätzlich eine Prüfeinrichtung zur Prüfung des ΔΣ-ADCs 2 vorgesehen, die einen als digitale Referenzeinrichtung dienenden digitalen ΔΣ-Referenzmodulator 8 und einen Testsignal-Generator 9 aufweist, wobei die bereits beschriebenen Multiplexer 4 und 5 sowie ein in dem Testsignal-Generator 9 vorgesehener Multiplexer 10 als Schalter dienen.

Der Testsignal-Generator 9 weist vorteilhafterweise einen digitalen Delta-Sigma-Modulator 11 niedriger Ordnung, z. B. lediglich erster Ordnung auf, der aus seinem Eingangssignal ein digitales Testsignal S5 mit einer Wortbreite von 1 Bit und einer Bandbreite von fs/2 erzeugt. Das digitale Testsignal S5 wird direkt dem digitalen ΔΣ -Referenzmodulator 8 eingegeben; weiterhin wird es über einen 1-Bit D/A-Wandler 12 in ein analoges Testsignal S6 konvertiert. Hierbei wird z. B. der digitale Wertebereich von (+1; -1) auf den entsprechenden analogen Wertebereich von (+U_{ref}; -U_{ref}) abgebildet, wobei Uref vorzugsweise der Referenzspannung des analogen ΔΣ -Modulators 3 entspricht. Das analoge Testsignal S6 wird hierbei an den Multiplexer 4 ausgegeben, der von einem Steuersignal S7 angesteuert wird und in Abhängigkeit von diesem wahlweise das analoge Eingangssignal S1 oder das analoge Testsignal S6 an den analogen ΔΣ -Modulator 3 ausgibt.

Fig. 3 zeigt eine schaltungstechnisch einfache kombinierte Ausbildung des DAC 12 und des Eingangsmultiplexers 4 durch einen gemeinsamen Schalter mit drei Eingängen für das analoge Eingangssignal S1 und die die analogen Werte beschreibenden Referenzspannungen +Uref und -Uref. Somit sind bei S7 = "0" die Schalter K2, K3 offen und der Schalter K1 geschlossen, bei S7 = "1" ist der Schalter K1 offen und in Abhängigkeit von S5 wechselseitig entweder K2 oder K3 geschlossen, um die Binärwerte [0, 1] auf [-Uref, +Uref] abzubilden, so dass die Schaltstellung von K2 durch S5 gesteuert wird und entsprechend die Schaltstellung von K3 durch den inversen Wert NOT (S5). Dementsprechend wird das analoge Signal S6 direkt durch Anschluss von +Uref oder -Uref gebildet.

Der digitale Referenzmodulator 8 bildet die Übertragungsfunktion (Z-Transformation) des analogen ΔΣ -Modulators 3 in Form eines exakten digitalen Rechenalgorithmus ideal nach. Er bildet hierbei aus seinem digitalen Eingangssignal S5 ein Pulsdichte moduliertes digitales Referenz-Datenstromsignal S8 der Wortbreite n_{sd} und der Bandbreite fs/2. Der digitale ΔΣ -Referenzmodulator 8 ist hierbei vorteilhafterweise hardwaremäßig ausgebildet; grundsätzlich kann der digitale Rechenalgorithmus jedoch auch z. B. softwaremäßig erfolgen.

Ein digitaler Addierer 13 bildet das Differenzsignal S10= S2 - S8 der Ausgangssignale des analogen ΔΣ -Modulators 3 und des digitalen Referenzmodulators 8. Da die Wortbreite n_{sd} dieser Signale gering ist, vorteilhafterweise 1 Bit, ist der entsprechende schaltungstechnische Aufwand für den digitalen Addierer 13 hier ebenfalls gering.

Dem digitalen ΔΣ -Modulator 11 des Testsignal-Generators 9 ist ein weiterer Multiplexer 14 vorgeschaltet, der das digitale Ausgangssignal S4 und weiterhin ein Testdaten-Eingangssignal S9 aufnimmt und eines dieser Signale S4, S9 in Abhängigkeit des Steuersignals S7 durchschaltet. Das Testdaten -Eingangssignal S9 weist hierbei eine Wortbreite nᵢₙ entsprechend dem aus dem digitalen Ausgangssignal S4 auf.

Das Testsignal S5 setzt sich somit aus dem modulierten Testdaten-Eingangssignal S9 oder dem rückgekoppelten Ausgangssignal S4 und einem Anteil aus dem Quantisierungsrauschen des ΔΣ- Modulators 11 zusammen. Die Wortbreite des Testdaten-Eingangssignals S9 wird gemäß Fig. 2 so gewählt, dass der Pegel des Quantisierungsrauschens über den gesamten Eingangsbereich größer ist als die Magnitudenschrittweite ΔM bezogen auf ein LSB (least significant bit) des Testdaten-Eingangssignals S9. Auf diese Weise wird ein Testsignal S5 erzeugt, welches einerseits aufgrund der geringen Wortbreite im eigentlichen Nutzband die gesamte Kennlinie mit wenigen, vorzugsweise 2 exp(nᵢₙ -1), in der Abszisse von Fig. 2 gezeigten Stützstellen abdeckt, und andererseits durch das überlagerte breitbandige Rauschen, welches ebenfalls als Bestandteil des Testsignals S5 wirksam ist, den gesamten Wertebereich des zu prüfenden Delta-Sigma-ADC 2 stimuliert.

Mit dem Steuersignal S7 können neben dem normalen Betriebsmodus, bei dem das analoge Eingangssignal S1 aufgenommen und das digitale Ausgangssignal S4 ausgegeben wird, mindestens drei Testmodi ausgewählt werden, die jeweils BIST (build in self test) - Testmodi darstellen:

In einem ersten und zweiten Testmodus werden die digitalen Komponenten der Anordnung getestet. Der Ausgang des analogen ΔΣ -Modulators 3 bleibt in diesen Betriebsarten ungenutzt.

Der erste Testmodus dient zur grundsätzlichen Funktionsüberprüfung. Über den Multiplexer 14 werden digitale Testdaten-Signale S9 an den Eingang des Testsignal-Generators 9 angelegt, der hieraus digitale Testsignale S5 bildet und an den Referenzmodulator 8 ausgibt. Das von dem Referenzmodulator 8 ausgegebene Referen-Datenstromsignal S8 gelangt über den Multiplexer 5 an den Eingang des Dezimierfilters 6 und wird von dort über das Tiefpassfilter 7 als Ausgangssignal S4 ausgegeben. Das Ausgangssignal S4 stellt folglich in dieser Betriebsart ein Abbild der Eingangsdaten dar und kann funktional durch direkten Vergleich geprüft werden.

Der zweite Testmodus wird als Modifikation des ersten Testmodus durch Rückkopplung des Ausgangssignals S4 auf den Testdaten-Eingang des Testsignal Generators 9 durchgeführt. Durch inverse Rückkopplung der vorzugsweise niederwertigen nᵢₙ Bit aus S4 entsteht das breitbandige pseudozufällige Testsignal S5, welches den gesamten beschriebenen Signalpfad in kurzer Zeit über den ganzen Wertbereich stimuliert.

Da der gesamte Signalpfad in dieser Betriebsart als synchrones digitales Netzwerk arbeitet, kann der eigentliche Test auf Basis von "Testpattern" durch wiederholte Prüfung der Ausgangsdaten S4 auf Identität mit den entsprechenden Simulationsergebnissen erfolgen. Durch Fehlersimulation der "Testpattern" ist die optimale Dauer der Prüfung für das Erreichen einer bestimmten Testabdeckung festzulegen. Alternativ zu einem strukturalen Test mittels Scanpfad kann auf diese Weise die bestimmungsgemäße Funktion der digitalen Anordnung mit kontrollierter Festabdeckung mittels automatisch erzeugter Stimuli geprüft werden.

Im dritten Testmodus wird der analoge ΔΣ -Modulator 3 verifiziert, indem sein Ausgangsdatenstrom mit dem des digitalen Referenzmodulators 8 bei identischer Stimulation verglichen wird.

Das Testdaten-Eingangssignal S9 gelangt über den Multiplexer 14 an den digitalen ΔΣ-Modulator 11 und erscheint an dessen Ausgang als pulsdichte moduliertes Testsignal S5 mit einer Wortbreite von 1 Bit und einer Bandbreite fs/2. Das digitale Testsignal S5 mit dem Wertebereich (+1; -1) wird wiederum in den Referenzmodulator 8 eingegeben und gleichzeitig in seiner analogen Form S6 mit dem entsprechenden Wertebereich (+Uref; -Uref) als Eingangssignal des zu prüfenden analogen ΔΣ -Modulators 3 verwendet. Der digitale Addierer 13 bildet das Differenzsignal S10 = S2 - S8, das über den Multiplexer 13 an die nachfolgenden Filterstufen 6 und 7 weitergeleitet wird. Die hochfrequenten Rauschanteile des Quantisierungsrauschens der Modulatoren 3 und 8 werden in den Filterstufen eliminiert und die Signalbandbreite auf (fs/2k) reduziert. Das verbleibende Signal S4 stellt damit die Differenz der Nutzsignalbänder von S10 dar. Da beide Modulatoren mit dem gleichen Eingangssignal stimuliert werden, ist das Ergebnis an S4 die Abweichung des ΔΣ -Modulators 3 von seinem idealen Referenzmodel 8 und stellt damit den jeweiligen Fehler in dem durch S9 definierten Arbeitspunkt dar. Indem der Wertebereich von S9 beispielsweise durch einen digitalen Zähler linear durchlaufen wird, erhält man am Ausgang S4 die Fehlerkennlinie des ΔΣ - ADC mit 2**nᵢₙ Stützstellen.

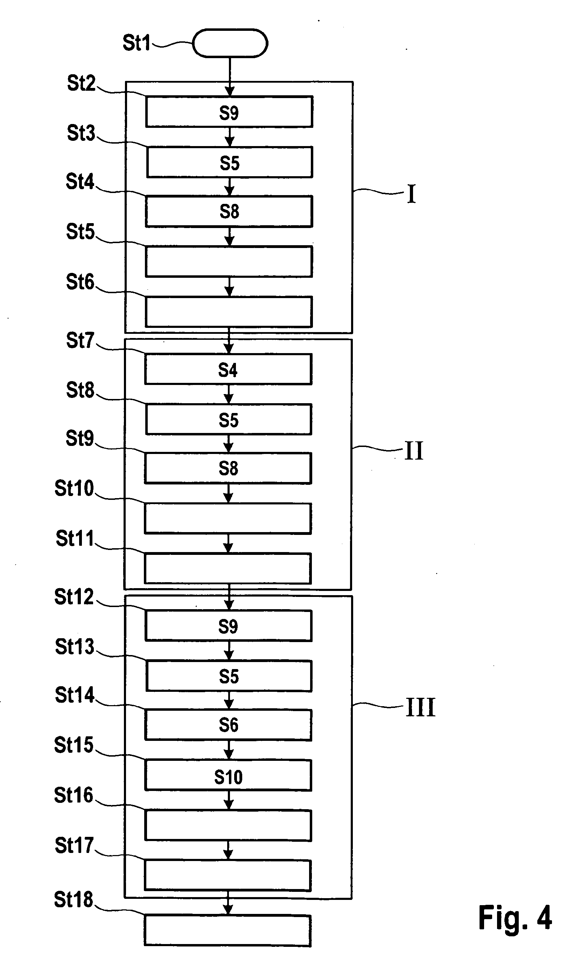

Figur 4 zeigt ein beispielhaftes Flussdiagramm, bei dem die drei Testmodi BIST 1, 2, 3 mit I, II, III gekennzeichnet sind und sukzessive durchgeführt werden; hierzu werden von außen über eine Steuereinrichtung die Steuersignale S7 an die Multiplexer 4, 5, 14 und das Testdaten-Eingangssignal S9 an den Multiplexer 14 eingegeben.

Nach dem Start in Schritt St1 wird in dem Testmodus BIST1 zunächst gemäß Schritt St2 das Testdaten-Eingangssignal S9 in den Testsignal-Generator 9 eingegeben und von diesem in Schritt St3 das digitale Testsignal S5 erzeugt und ausgegeben, nachfolgend in Schritt St4 aus dem digitalen Testsignal S5 von dem digitalen ΔΣ - Referenzmodulator 8 das digitale Referenz-Datenstromsignal S8 erzeugt, das in Schritt St5 von der digitalen Filtereinrichtung 6, 7, gefiltert wird, und nachfolgend in Schritt St6 ausgewertet wird.

In dem Testmodus BIST 2 wird in Schritt St7 das digitale Ausgangssignal S4 dem Testsignal-Generator 9 zugeführt und von diesem in Schritt St8 ein digitales Testsignal S5 ausgegeben und dem digitalen ΔΣ-Referenzmodulator 8 zugeführt, der in Schritt St9 das Referenz-Datenstromsignal S8 bildet, das in Schritt St10 nachfolgend gefiltert und in Schritt St11 ausgewertet wird.

Der Testmodus BIST 3 wird nachfolgend durchgeführt, indem in Schritt St12 das Signal S9 eingegeben wird und in Schritt St13 zunächst wiederum das digitale Testsignal S5 gebildet wird, nachfolgend in Schritt St14 aus diesem über den Digital-Analog-Wandlers 12 auch das analoge Testsignal S6 gebildet und über den Multiplexer 4 dem analogen ΔΣ -Modulator 3 zugeführt wird, wobei nachfolgend in Schritt St15 das Differenzsignal S10 gebildet wird und nach Filterung in Schritt St16 nachfolgend in Schritt St17 ausgewertet wird, wobei ergänzend in BIST3 auch die Signale S2 und S8 einzeln gefiltert und ausgewertet werden können.

Somit ist in Schritt St17 das Selbsttestverfahren bzw. Prüfungsverfahren beendet, so dass nachfolgend in Schritt St18 die Messung durch Aufnahme und Auswertung der analogen Eingangssignale S1 beginnen kann.

## Patentansprüche

1. Delta-Sigma-Datenkonverter-Anordnung, die mindestens aufweist:
einen analogen Delta-Sigma-Modulator (3) zur Aufnahme eines analogen Eingangssignals (S1) und Ausgabe eines digitalen Datenstromsignals (S2),
eine digitale Filtereinrichtung (6, 7), die abhängig von dem digitalen Datenstromsignal (S2) ein digitales Ausgangssignals (S4) ausgibt, **gekennzeichnet durch**
einen Testsignal-Generator (9; 11, 12, 14), der in Abhängigkeit des digitalen Ausgangssignals (S4) ein Testsignal (S5, S6) erzeugt,
eine digitale Referenzeinrichtung (8) zur Aufnahme des Testsignals (S5) und Ausgabe eines digitalen Referenz-Datenstromsignals (S8), und
eine Signalaufnahmeeinrichtung (13, 5) zum Aufnehmen des digitalen Datenstromsignals (S2) und des digitalen Referenz-Datenstromsignals (S8) und Ausgeben zumindest des digitalen Datenstromsignals (S2) und des digitalen Referenz-Datenstromsignals (S8) an die digitale Filtereinrichtung (6, 7).

2. Delta-Sigma-Datenkonverter-Anordnung nach Anspruch 1, **dadurch gekennzeichnet, dass** die Signalaufnahmeeinrichtung (13, 5) in Abhängigkeit eines Steuersignals (s7) das Datenstromsignal (S2) oder das Referenz-Datenstromsignal (S8) oder ein aus diesen beiden Signalen (S2, S10) ermitteltes Signal (S10) an die digitale Filtereinrichtung (6, 7) ausgibt.

3. Delta-Sigma-Datenkonverter-Anordnung nach Anspruch 2, **dadurch gekennzeichnet, dass** die Signalaufnahmeeinrichtung (13, 5) einen digitalen Addierer (13) und eine Schalteinrichtung (5) aufweist, wobei der digitale Addierer (13) ein Differenzsignal (S10) des Datenstromsignals (S2) und des Referenz-Datenstromsignals (S8) bildet und die Schalteinrichtung (5) in Abhängigkeit eines Steuersignals (S7) das Differenzsignal (S10) oder das Datenstromsignal (S2) oder das Referenz-Datenstromsignal (S8) ausgibt.

4. Delta-Sigma-Datenkonverter-Anordnung nach einem der vorherigen Ansprüche, **dadurch gekennzeichnet, dass** der Testsignal-Generator (9) das digitale Ausgangssignal (S4) der digitalen Filtereinrichtung (6, 7) aufnimmt und in Abhängigkeit von diesem das digitale Testsignal (S5) bildet und ausgibt.

5. Delta-Sigma-Datenkonverter-Anordnung nach einem der vorherigen Ansprüche, **dadurch gekennzeichnet, dass** der Testsignal-Generator (9) ein digitales Testsignal (S5) an die digitale Referenzeinrichtung (8) und ein dem digitalen Testsignal (S5) entsprechendes analoges Testsignal (S6) an den analogen Delta-Sigma-Modulator (3) ausgibt.

6. Delta-Sigma-Datenkonverter-Anordnung nach Anspruch 5, **dadurch gekennzeichnet, dass** der Testsignal-Generator (9) einen Digital-Analog-Wandler (12) aufweist, der das digitale Testsignal (S5) in das entsprechende analoge Testsignal (S6) umwandelt, wobei die Referenzspannungen des Digital-Analog-Wandlers (12) den Referenzspannungen des analogen Delta-Sigma-Modulators (3) entsprechen.

7. Delta-Sigma-Datenkonverter-Anordnung nach einem der vorherigen Ansprüche, **dadurch gekennzeichnet, dass** die digitale Referenzeinrichtung (8) einen digitalen Delta-Sigma-Referenzmodulator (8) aufweist, der eine Übertragungsfunktion des analogen Delta-Sigma-Modulators (3) als digitalen Rechenalgorithmus nachbildet und ein Pulsdichte moduliertes digitales Referenz-Datenstromsignal (S8) der gleichen Wortbreite und Bandbreite wie das digitale Datenstrom-Signal (S2) ausgibt.

8. Delta-Sigma-Datenkonverter-Anordnung nach einem der vorherigen Ansprüche, **dadurch gekennzeichnet, dass** der Testsignal-Generator (9) einen digitalen Delta-Sigma-Modulator (11) zur Erzeugung des Testsignals (S5) als Pulsdichte modulierten Datenstrom, vorzugsweise Bit-Strom aufweist.

9. Delta-Sigma-Datenkonverter-Anordnung nach einem der vorherigen Ansprüche, **dadurch gekennzeichnet, dass** die digitale Filtereinrichtung (6, 7) einen Dezimierfilter (6) zur Filterung und Abtastratenreduzierung und einen digitalen Tiefpassfilter (7) zur Unterdrückung von Rauschanteilen und zur Kompensation der Übertragungscharakteristik im Nutzband aufweist.

10. Delta-Sigma-Datenkonverter-Anordnung nach einem der vorherigen Ansprüche, **dadurch gekennzeichnet, dass** sie vollständig als integrierter Schaltkreis ausgebildet ist.

11. Verfahren zum Prüfen eines Delta-Sigma-Datenkonverters (2), der einen analogen Delta-Sigma-Modulator (3) zur Aufnahme eines analogen Eingangssignals (S1) und Ausgabe eines digitalen Datenstrom-Signals (S2) und eine digitale Filtereinrichtung (6, 7) zur Ausgabe eines digitalen Ausgangssignals (S4) in Abhängigkeit von dem digitalen Datenstrom (S2) aufweist, wobei
dem analogen Delta-Sigma-Modulator (3) und einer digitalen Referenzeinrichtung (8) Testsignale (S5, S6) zugeführt werden und das von dem analogen Delta-Sigma-Modulator (3) ausgegebene Datenstrom-Signal (S2) und das von der digitalen Referenzeinrichtung (8) ausgegebene Referenz-Datenstromsignal (S8) an die digitale Filtereinrichtung (6, 7) ausgegeben und das von der digitalen Filtereinrichtung (6, 7) ausgegebenen digitale Ausgangssignal (S4) ausgewertet wird.

12. Verfahren nach Anspruch 11, **dadurch gekennzeichnet, dass** wahlweise ein Datenstrom-Signal (S2) des analogen Delta-Sigma-Modulators (3) oder ein Referenz- Datenstromsignal (S8) der digitalen Referenzeinrichtung (8) oder ein aus diesen Signalen (S2, S8) gebildetes Differenzsignal (S10) digital gefiltert und ausgewertet wird.

13. Verfahren nach Anspruch 11 oder 12, **dadurch gekennzeichnet, dass** in einem ersten Testmodus (BIST1) Testdaten-Eingangssignale (S9) einem Testsignal-Generator (9) zugeführt werden, der ein digitales Testsignal (S5) erzeugt und an die digitale Referenzeinrichtung (8) ausgibt, woraufhin das digitale Ausgangssignal (S4) mit dem Testdaten-Eingangssignal (S9) verglichen wird.

14. Verfahren nach einem der Ansprüche 11 bis 13, **dadurch gekennzeichnet, dass** in einem zweiten Testmodus (BIST2) das von der digitalen Filtereinrichtung (6, 7) ausgegebene digitale Ausgangssignal (S4) oder ein anderes aus dem digitalen Referenzmodulator-Signal (S8) abgeleitetes Signal an den Testsignal-Generator (9) zurückgekoppelt wird.

15. Verfahren nach Anspruch 14, **dadurch gekennzeichnet, dass** durch die Rückkopplung ein synchrones digitales Netzwerk ausgebildet wird und wiederholt Testmuster gebildet und ausgewertet werden.

16. Verfahren nach einem der Ansprüche 11 bis 15, **dadurch gekennzeichnet, dass** in einem dritten Testmodus der digitalen Referenzeinrichtung (8) das digitale Testsignal (S5) und dem analogen Delta-Sigma-Modulator (3) ein dem digitalen Testsignal (S5) entsprechendes analoges Testsignal (S6) zugeführt werden und das von dem Delta-Sigma-Modulator (3) ausgegebene Datenstrom-Signal (S2) und das von der digitalen Referenzeinrichtung (8) ausgegebene Referenz-Datenstromsignal (S8) miteinander verglichen werden.

17. Verfahren nach dem Anspruch 16, **dadurch gekennzeichnet, dass** aus dem Datenstrom-Signal (S2) und dem Referenz-Datenstromsignal (S8) ein Differenzsignal (10) gebildet wird und wahlweise das Datenstrom-Signal (S2) oder das Referenz-Datenstromsignal (S8) oder das Differenzsignal (10) über die digitale Filtereinrichtung (6, 7) als digitale Ausgangssignale (S4) ausgegeben und ausgewertet werden.

18. Verfahren nach Anspruch 17, **dadurch gekennzeichnet, dass** das Testdaten-Eingangssignal (S9) mittels eines digitalen Zählers einen Wertebereich linear durchläuft und das Differenzsignal (S10) als Fehlerkennlinie des analogen Delta-Sigma-Modulators (3) ausgewertet wird, wobei die Wortbreite (nin) des Testdaten-Eingangssignals (S9) die Anzahl (2**nin) der Stützstellen der Fehlerkennlinie festlegt.

19. Verfahren nach einem der Ansprüche 11 bis 18, **dadurch gekennzeichnet, dass** Offset, Steigung und nichtlineare Fehler des Delta-Sigma-Datenkonverters (2) ermittelt und zumindest teilweise kompensiert werden.

## Claims

1. Delta-sigma data converter arrangement having at least:
an analogue delta-sigma modulator (3) for receiving an analogue input signal (S1) and outputting a digital data stream signal (S2),
a digital filter device (6, 7) which outputs a digital output signal (S4) on the basis of the digital data stream signal (S2), **characterized by**
a test signal generator (9; 11, 12, 14) which generates a test signal (S5, S6) on the basis of the digital output signal (S4),
a digital reference device (8) for receiving the test signal (S5) and outputting a digital reference data stream signal (S8), and
a signal receiving device (13, 5) for receiving the digital data stream signal (S2) and the digital reference data stream signal (S8) and outputting at least the digital data stream signal (S2) and the digital reference data stream signal (S8) to the digital filter device (6, 7).

2. Delta-sigma data converter arrangement according to Claim 1, **characterized in that** the signal receiving device (13, 5) outputs the data stream signal (S2) or the reference data stream signal (S8) or a signal (S10) determined from these two signals (S2, S8) to the digital filter device (6, 7) on the basis of a control signal (S7).

3. Delta-sigma data converter arrangement according to Claim 2, **characterized in that** the signal receiving device (13, 5) has a digital adder (13) and a switching device (5), the digital adder (13) forming a differential signal (S10) of the data stream signal (S2) and the reference data stream signal (S8), and the switching device (5) outputting the differential signal (S10) or the data stream signal (S2) or the reference data stream signal (S8) on the basis of a control signal (S7).

4. Delta-sigma data converter arrangement according to one of the preceding claims, **characterized in that** the test signal generator (9) receives the digital output signal (S4) from the digital filter device (6, 7) and forms and outputs the digital test signal (S5) on the basis of said digital output signal.

5. Delta-sigma data converter arrangement according to one of the preceding claims, **characterized in that** the test signal generator (9) outputs a digital test signal (S5) to the digital reference device (8) and outputs an analogue test signal (S6) corresponding to the digital test signal (S5) to the analogue delta-sigma modulator (3).

6. Delta-sigma data converter arrangement according to Claim 5, **characterized in that** the test signal generator (9) has a digital/analogue converter (12) which converts the digital test signal (S5) into the corresponding analogue test signal (S6), the reference voltages of the digital/analogue converter (12) corresponding to the reference voltages of the analogue delta-sigma modulator (3).

7. Delta-sigma data converter arrangement according to one of the preceding claims, **characterized in that** the digital reference device (8) has a digital delta-sigma reference modulator (8) which simulates a transfer function of the analogue delta-sigma modulator (3) in the form of a digital computing algorithm and outputs a pulse-density-modulated digital reference data stream signal (S8) having the same word length and bandwidth as the digital data stream signal (S2).

8. Delta-sigma data converter arrangement according to one of the preceding claims, **characterized in that** the test signal generator (9) has a digital delta-sigma modulator (11) for generating the test signal (S5) in the form of a pulse-density-modulated data stream, preferably a bit stream.

9. Delta-sigma data converter arrangement according to one of the preceding claims, **characterized in that** the digital filter device (6, 7) has a decimation filter (6) for filtering and for reducing the sampling rate and a digital low-pass filter (7) for suppressing noise components and for compensating for the transmission characteristic in the useful band.

10. Delta-sigma data converter arrangement according to one of the preceding claims, **characterized in that** it is completely in the form of an integrated circuit.

11. Method for testing a delta-sigma data converter (2) having an analogue delta-sigma modulator (3) for receiving an analogue input signal (S1) and outputting a digital data stream signal (S2) and a digital filter device (6, 7) for outputting a digital output signal (S4) on the basis of the digital data stream (S2),
test signals (S5, S6) being supplied to the analogue delta-sigma modulator (3) and to a digital reference device (8), and the data stream signal (S2) output by the analogue delta-sigma modulator (3) and the reference data stream signal (S8) output by the digital reference device (8) being output to the digital filter device (6, 7), and the digital output signal (S4) output by the digital filter device (6, 7) being evaluated.

12. Method according to Claim 11, **characterized in that** either a data stream signal (S2) from the analogue delta-sigma modulator (3) or a reference data stream signal (S8) from the digital reference device (8) or a differential signal (S10) formed from these signals (S2, S8) is digitally filtered and evaluated.

13. Method according to Claim 11 or 12, **characterized in that**, in a first test mode (BIST1), test data input signals (S9) are supplied to a test signal generator (9) which generates a digital test signal (S5) and outputs it to the digital reference device (8), whereupon the digital output signal (S4) is compared with the test data input signal (S9).

14. Method according to one of Claims 11 to 13, **characterized in that**, in a second test mode (BIST2), the digital output signal (S4) output by the digital filter device (6, 7) or another signal derived from the digital reference modulator signal (S8) is fed back to the test signal generator (9).

15. Method according to Claim 14, **characterized in that**, as a result of the feedback, a synchronous digital network is formed and test patterns are repeatedly formed and evaluated.

16. Method according to one of Claims 11 to 15, **characterized in that**, in a third test mode, the digital test signal (S5) is supplied to the digital reference device (8) and an analogue test signal (S6) corresponding to the digital test signal (S5) is supplied to the analogue delta-sigma modulator (3) and the data stream signal (S2) output by the delta-sigma modulator (3) and the reference data stream signal (S8) output by the digital reference device (8) are compared with one another.

17. Method according to Claim 16, **characterized in that** a differential signal (S10) is formed from the data stream signal (S2) and the reference data stream signal (S8) and either the data stream signal (S2) or the reference data stream signal (S8) or the differential signal (S10) is output in the form of a digital output signal (S4) via the digital filter device (6, 7) and is evaluated.

18. Method according to Claim 17, **characterized in that** the test data input signal (S9) runs through a range of values in a linear manner by means of a digital counter and the differential signal (S10) is evaluated as an error characteristic curve of the analogue delta-sigma modulator (3), the word length (nin) of the test data input signal (S9) defining the number (2**nin) of support points of the error characteristic curve.

19. Method according to one of Claims 11 to 18, **characterized in that** offset, gradient and nonlinear errors of the delta-sigma data converter (2) are determined and at least partially compensated for.

## Revendications

1. Système de conversion delta-sigma de données, qui présente au moins :
- un modulateur analogique delta-sigma (3) qui reçoit un signal analogique d'entrée (S1) et délivre un signal numérique (S2) de flux de données,
- un dispositif (6, 7) de filtrage numérique qui, délivre un signal numérique de sortie (S4) en fonction du signal numérique (S2) de flux de données,
**caractérisé par**
un générateur (9; 11, 12, 14) de signaux de test qui forme un signal de test (S5, S6) en fonction du signal numérique de sortie (S4),
un dispositif numérique de référence (8) qui reçoit le signal de test (S5) et délivre un signal numérique (S8) de flux de données de référence et
un dispositif (13, 5) de réception de signaux qui reçoit le signal numérique (S2) de flux de données et le signal numérique (S8) de flux de données de référence et qui délivre au moins le signal numérique (S2) de flux de données et le signal numérique (S8) de flux de données de référence au dispositif (6, 7) de filtrage numérique.

2. Système de conversion delta-sigma de données selon la revendication 1, **caractérisé en ce que** le dispositif (13, 5) de réception des signaux délivre au dispositif (6, 7) de filtrage numérique le signal (S2) de flux de données, le signal (S8) de flux de données de référence ou un signal (S10) déterminé à partir de ces deux signaux (S2, S8) en fonction d'un signal de commande (S7).

3. Système de conversion delta-sigma de données selon la revendication 2, **caractérisé en ce que** le dispositif (13, 5) de réception de signaux présente un additionneur numérique (13) et un dispositif de commutation (5), l'additionneur numérique (13) formant un signal de différence (S10) entre le signal (S2) de flux de données et le signal (S8) de flux de données de référence, le dispositif de commutation (5) délivrant le signal de différence (S10), le signal (S2) de flux de données ou le signal (S8) de flux de données de référence en fonction d'un signal de commande (S7).

4. Système de conversion delta-sigma de données selon l'une des revendications précédentes, **caractérisé en ce que** le générateur (9) de signaux de test reçoit le signal numérique de sortie (S4) du dispositif (6, 7) de filtrage numérique et forme et délivre le signal numérique de test (S5) en fonction du signal numérique de sortie.

5. Système de conversion delta-sigma de données selon l'une des revendications précédentes, **caractérisé en ce que** le générateur (9) de signaux de test délivre un signal numérique de test (S5) au dispositif numérique de référence (8) et un signal analogique de test (S6), qui correspond au signal numérique de test (S5), au modulateur analogique delta-sigma (3).

6. Système de conversion delta-sigma de données selon la revendication 5, **caractérisé en ce que** le générateur (9) de signaux de test présente un convertisseur numérique-analogique (12) qui convertit le signal numérique de test (S5) en le signal analogique de test (S6) qui y correspond, les tensions de référence du convertisseur numérique-analogique (12) correspondant aux tensions de référence du modulateur analogique delta-sigma (3).

7. Système de conversion delta-sigma de données selon l'une des revendications précédentes, **caractérisé en ce que** le dispositif numérique de référence (8) présente un modulateur numérique delta-sigma de référence (8) qui forme une fonction de transfert du modulateur analogique delta-sigma (3) sous la forme d'un algorithme numérique de calcul et délivre un signal numérique (S8) de flux de données de référence à densité d'impulsions modulée qui présente la même largeur de mot et la même bande passante que le signal numérique (S2) de flux de données.

8. Système de conversion delta-sigma de données selon l'une des revendications précédentes, **caractérisé en ce que** le générateur (9) de signaux de test présente un modulateur numérique delta-sigma (11) qui forme le signal de test (S5) sous la forme d'un flux de données à densité d'impulsions modulée, de préférence un flux de bits.

9. Système de conversion delta-sigma de données selon l'une des revendications précédentes, **caractérisé en ce que** le dispositif de filtrage numérique (6, 7) présente un filtre décimant (6) qui filtre et réduit le taux d'échantillonnage et un filtre numérique passe-bas (7) qui abaisse les composantes de bruit et compense la caractéristique de transmission dans la bande utile.

10. Système de conversion delta-sigma de données selon l'une des revendications précédentes, **caractérisé en ce qu'**il est configuré complètement comme circuit intégré.

11. Procédé de vérification d'un convertisseur delta-sigma (2) de données qui présente un modulateur analogique delta-sigma (3) qui reçoit un signal d'entrée analogique (S1) et qui délivre un signal numérique (S2) de flux de données et un dispositif (6, 7) de filtrage numérique qui délivre un signal numérique de sortie (S4) en fonction du flux de données numériques (S2),
des signaux de test (S5, S6) étant amenés au modulateur analogique delta-sigma (3) et à un dispositif numérique de référence (8), le signal (S2) de flux de données délivré par le modulateur analogique delta-sigma (3) et le signal (S8) de flux de données de référence délivré par le dispositif numérique de référence (8) étant délivrés au dispositif (6, 7) de filtrage numérique, le signal numérique de sortie (S4) délivré par le dispositif (6, 7) de filtrage numérique étant évalué.

12. Procédé selon la revendication 11, **caractérisé en ce qu'**un signal (S2) de flux de données du modulateur analogique delta-sigma (3), un signal (S8) de flux de données de référence du dispositif numérique de référence (8) ou un signal de différence (S10) formé à partir de ces deux signaux (S2, S8) sont filtrés numériquement et évalués.

13. Procédé selon les revendications 11 ou 12, **caractérisé en ce que** dans un premier mode de test (BIST1), les signaux d'entrée (S9) de données de test sont apportés à un générateur (9) de signaux de test qui forme un signal numérique de test (S5) et le délivre au dispositif numérique de référence (8), le signal numérique de sortie (S4) étant ensuite comparé au signal d'entrée (S9) de données de test.

14. Procédé selon l'une des revendications 11 à 13, **caractérisé en ce que** dans un deuxième mode de test (BIST2), le signal numérique de sortie (S4) délivré par le dispositif (6, 7) de filtrage numérique ou un autre signal dérivé du signal numérique (S8) du modulateur de référence rétroagissent sur le générateur (9) de signaux de test.

15. Procédé selon la revendication 14, **caractérisé en ce que** la rétroaction forme un réseau numérique synchrone et **en ce que** des motifs de test sont formés et évalués à répétition.

16. Procédé selon l'une des revendications 11 à 15, **caractérisé en ce que** dans un troisième mode de test, le signal numérique de test (S5) est amené au dispositif numérique de référence (8) et un signal analogique de test (S6) qui correspond au signal numérique de test (S5) est amené au modulateur delta-sigma analogique (3), le signal (S2) de flux de données délivré par le modulateur delta-sigma (3) et le signal (S8) de flux de données de référence délivré par le dispositif numérique de référence (8) étant comparés l'un à l'autre.

17. Procédé selon la revendication 16, **caractérisé en ce qu'**un signal de différence (S10) est formé à partir du signal (S2) de flux de données et du signal (S8) de flux de données de référence, le signal (S2) de flux de données, le signal (S8) de flux de données de référence ou le signal de différence (S10) étant sélectivement délivrés par l'intermédiaire du dispositif (6, 7) de filtrage numérique sous la forme de signaux numériques de sortie (S4) et étant évalués.

18. Procédé selon la revendication 17, **caractérisé en ce que** le signal d'entrée (S9) de données de test balaye linéairement une plage d'évaluation au moyen d'un compteur numérique et **en ce que** le signal de différence (S10) est évalué comme ligne caractéristique d'erreurs du modulateur delta-sigma analogique (3), la largeur des mots (nin) du signal d'entrée (S9) de données de test définissant le nombre (2**nin) de points d'appui de la ligne caractéristique d'erreurs.

19. Procédé selon l'une des revendications 11 à 18, **caractérisé en ce que** le décalage, la pente et les erreurs non linéaires du convertisseur delta-sigma (2) de données sont déterminés et au moins partiellement compensés.
